# EUROPEAN PATENT APPLICATION

(11) **EP 2 387 075 A2**
(43) Date of publication of application: **16.11.2011**
(21) Application number: 10197288.3
(22) Date of filing: 29.12.2010
(51) Int. Cl.: H01L 27/088, H03K 17/08

(54) **Current sensor for a semiconductor device and system**

(30) Priority: 30.12.2009 US 291107 P; 26.02.2010 US 308565 P; 21.09.2010 US 886763
(71) Applicant: Intersil Americas Inc., Milpitas, CA 95035 (US)
(72) Inventor: Girdhar, Dev Alok, Indiatlantic, FL 32903 (US); Hebert, Francois, San Mateo, CA 94402 (US)
(74) Representative: Fleuchaus, Michael A.

(57) **Abstract**

A current sensor which can be used to measure current flowing through a semiconductor substrate of a direct current (DC) to DC converter or other device. The current sensor can provide continuous measurements during operation of the DC to DC converter. In one embodiment, a first current sensor can be use to measure current flow through a high side transistor and a second current sensor can be used to measure current flow through a low side transistor. In another embodiment, a single current sensor can be used to measure current flow through a semiconductor substrate whether the high side transistor is on or off, the low side transistor is on or off, or during switching of either the high side transistor or low side transistor.

## Description

### Cross Reference to Related Application

This application claims the benefit of U.S. Provisional Application 61/308,565 filed February 26, 2010, and is related to U.S. Patent Publication No. 2010-0155836-A1, published on June 24, 2010 and U.S Provisional Application 61/291,107, filed December 30, 2009, all of which are incorporated herein by reference.

### Description of the Present Teachings

Reference below is made in detail to exemplary embodiments of the present teachings, examples of which are illustrated in the accompanying drawings. Wherever possible, the same reference numbers will be used throughout the drawings to refer to the same or like parts. The accompanying drawings, which are incorporated in and constitute a part of this specification, illustrate embodiments of the present teachings and together with the description, serve to explain the principles of the present teachings. In the figures:

FIG. 1 is a cross section depicting a portion of a structure which can include a vertical diffused metal oxide semiconductor (VDMOS) device, a laterally diffused metal oxide semiconductor (LDMOS), and an arrangement of current sense electrodes in accordance with one embodiment of the present teachings;

FIG. 2 is a cross section depicting a portion of a structure which can include two current sensors which have separate bottom electrodes;

FIG. 3 is a cross section depicting a portion of a structure which can include top electrodes which electrically contact a top surface of a semiconductor substrate so that a full semiconductor substrate thickness can be used for current measurement;

FIG. 4 is a cross section depicting a portion of a structure which can include implanted electrode portions;

FIG. 5 is a cross section depicting a structure which can include a single current sensor;

FIG. 6 is a cross section depicting a device in accordance with the present teachings including a lead frame, bond wires, and a PowerDie attached to a die pad of the lead frame;

FIG. 7 is a schematic depiction of an embodiment of the present teachings;

FIG. 8 is a graph depicting current measurements during simulated operation of a DC to DC converter to determine the placement of a sense electrode during design of a device in accordance with an embodiment of the present teachings;

FIG. 9 is an electronic system in accordance with an embodiment of the present teachings; and

FIGS. 10-24 are cross sections depicting intermediate structures formed during embodiments of the present teachings.

It should be noted that some details of the FIGS. have been simplified and are drawn to facilitate understanding of the inventive embodiments rather than to maintain strict structural accuracy, detail, and scale.

Reference will now be made in detail to exemplary embodiments of the present teachings, an example of which is illustrated in the accompanying drawings.

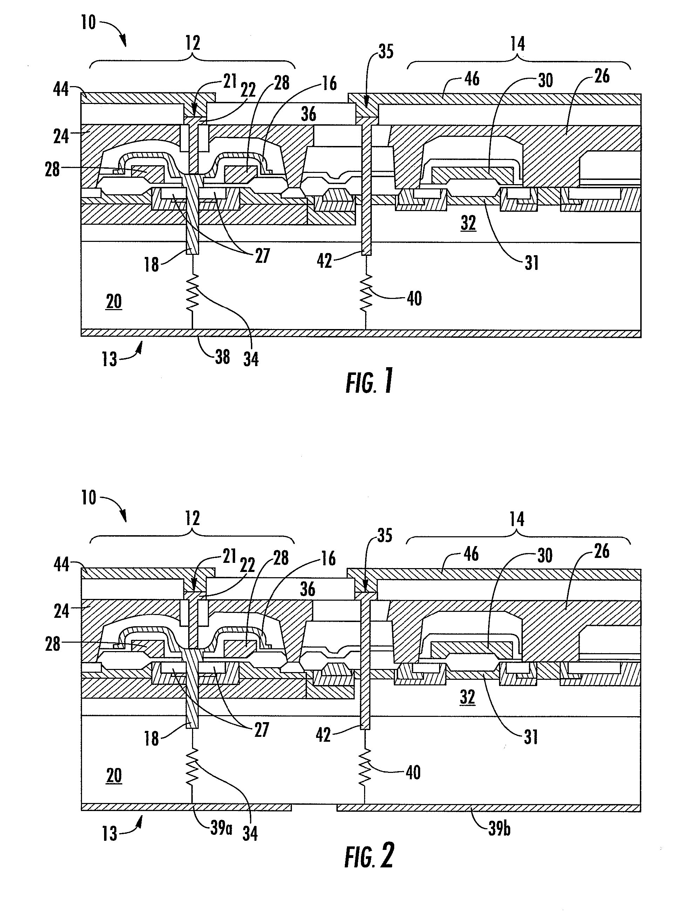

U.S. Patent Application Serial No. 12/470,229 (hereinafter, "S/N '229") describes a DC to DC power converter (hereinafter, "converter") which can include an N-type LDMOS as a high side power metal oxide semiconductor field effect transistor (MOSFET) and an n-type VDMOS as a low side power MOSFET. The FIG. 1 power converter device 10 depicts a high side transistor 12 which can include an LDMOS FET at a first location and low side transistor 14 which can include a VDMOS at a second location. A device having both a high side power MOSFET and a low side power MOSFET on a single semiconductor substrate which is part of a single semiconductor die is referred to herein as a "PowerDie."

An embodiment of the present teachings can include the PowerDie method and structure of '229 along with one or more current sensors, which can be provided by one or more current sense resistors (referred to herein as "sense resistors" or "sensors"), as described herein. Embodiments of the present teachings can be used with other semiconductor device transistors as well, for example transistors having a vertical current flow and ohmic contact to a semiconductor substrate.

The FIG. 1 structure can include a semiconductor substrate 20, such as a semiconductor wafer, a portion of a semiconductor wafer, or an epitaxial semiconductor layer. The device can further include an epitaxial layer 32, as well as other layers, formed over the semiconductor substrate 20, and doped or implanted regions within the semiconductor substrate. In the depicted structure, the device includes semiconductor substrate 20, for example a silicon substrate, having an N-type epitaxial layer 32 formed on the semiconductor substrate 20. The FIG. 1 further depicts two current sensors in accordance with the present teachings, although devices having only one current sensor, or more than two current sensors, are contemplated. A first current sensor 21 includes a top electrode 22, a lower extension 18 of a transistor gate shield 16, and a bottom electrode 38. The bottom electrode 38 can be a metal layer formed on the back side of the semiconductor substrate 20. A second current sensor 35 includes a top electrode 36, a lower extension 42 of the second current sensor top electrode 36, and a bottom electrode 38.

In FIG. 1, a single bottom electrode 38 is common to both the first current sensor 21 and the second current sensor 35. It is contemplated, however, that the first current sensor 21 can include a first bottom electrode 39A and the second current sensor 35 can include a second bottom electrode 39B which is separate from the first bottom electrode 39A, such as that depicted in FIG. 2.

The high side transistor 12 can include a transistor source 27 and a transistor gate 28. FIG. 1 includes two portions of the same transistor gate 28 being depicted in cross section. The LDMOS device further includes a transistor drain 24 which is adapted to be tied to device voltage in (V_{IN}), for example through a pinout such as a lead frame lead which is wire bonded to the LDMOS transistor drain 24. A source of the LDMOS device is electrically coupled to the back surface of the semiconductor substrate 20, which can be accessed by contact with the bottom electrode 38. The transistor gate shield 16 shields the transistor gate 28 and reduces the effect of electrical interference from the drain 24 during device operation. The transistor gate shield can thus reduce gate-drain capacitance (C_{GD}) and the effects of an electric field surrounding the drain 24.

The VDMOS FET 14 can include a transistor gate 30 and a transistor source 26. The transistor source 26 of the VDMOS device is adapted to be tied to device ground (P_{GND}), for example through a pinout such as a lead frame lead which is wire bonded to the VDMOS transistor source 26. In FIG. 1, the VDMOS FET 14 is shown as a planar DMOS, but this FET can also be a Trench DMOS (TDMOS), which can be implemented by one of ordinary skill in the art from the information herein. Other devices are also contemplated.

The transistor gate shield 16 may be present in an embodiment of the present teachings, but is not a necessary element. If present, the lower extension 18 of the transistor gate shield 16 can be formed within a trench in the semiconductor substrate 20, such as the trench 23 within semiconductor substrate 20 depicted in FIG. 1 within which lower electrode 18 is formed. Further, a portion of the high side transistor, for example the gate shield 16, can be directly interposed between the top electrode 22 and the semiconductor substrate 20. During formation, the semiconductor substrate 20 at the bottom of the trench can be heavily doped to an N-type conductivity (i.e. N+++ doped), for example to a concentration of about 1E19 atoms/cm³ to about 5E20 atoms/cm³ . The N-type epitaxial layer can be doped to a concentration of about 1E14 atoms/cm³ to about 1E17 atoms/cm³, depending on the desired operating voltage of the transistor.

As discussed above, FIG. 1 depicts two separate sensors, 21, 35. "Sense pads" for the first sensor 21 are provided by top electrode 22 and bottom electrode 38. Sense pads for the second sensor 35 are provided by top electrode 36 and bottom electrode 38.

In the device depicted at FIG. 1, the bottom electrode 38 is common to both sensors. Further, in this device, the source 27 of the high side transistor 12 is electrically coupled to the N+++ doped semiconductor substrate 20 through the lower extension 18 of the transistor gate shield 16. That is, the conductive lower extension 18 makes contact with the source 27 of the high side transistor 12 and with the doped semiconductor substrate 20, and electrically couples the high side transistor source 27 to the semiconductor substrate 20. The lower extension 18 is electrically coupled to the bottom electrode 38 through the small series resistance 34 of the portion of N+++ semiconductor substrate 20 which separates lower extension 18 and bottom electrode 38. The drain of the low side transistor 14 is provided in part by region 31, and includes the portions of epitaxial layer 32 and N+++ layer 20 located below region 31 extending to bottom electrode 38. The source 27 of the high side transistor 12 and drain portion 31 of the low side transistor 14 are thus tied together through lower electrode 18, the small resistance 34 of semiconductor substrate 20, and the bottom electrode 38. The back side of the semiconductor substrate therefore provides an output (i.e. phase node, switched node) of the DC to DC converter. Bottom electrode 38 can thus provide a contact to the phase node of the DC to DC converter device.

The first sensor 21 can be used to measure current flow through the high side transistor 12, and the second sensor 35 can be used to provide a measurement of current flow through the low side transistor 14. A measurement of resistance 34 of the semiconductor substrate 20 by the first sensor 21 can be used to provide the current measurement through the high side transistor 14. Similarly, a measurement of resistance 40 of the semiconductor substrate 20 by the second sensor 35 can be used to provide the current measurement through the low side transistor 14.

Electrical connection to the bottom electrode 38 can be made by attaching the device 10 to a lead frame die pad with a conductive die attach adhesive, for example conductive epoxy with conductive fillers such as silver, eutectic die attach using backmetal such as TiAu, and solder die attach. One or more lead frame leads connected directly to the die pad can provide outputs for both sensors, as well as the output node of the DC to DC converter device 10.

Electrical connection to the top electrodes 22, 36 of sensors 21, 35 can be made using an electrical conductor such as a bond wire, a copper clip, a stacked lead frame, or another electrical conductor for each sensor. One bond wire can be attached to each top electrode 22, 35 using direct attachment, or through attachment to an intervening conductive layer 44, 46 which is connected to the top electrodes 22, 36 respectively.

As depicted in FIG. 1, the lower extension 18 of the transistor gate shield 16 extends through the epitaxial layer 32 and into a trench within the semiconductor layer 20, for example a semiconductor wafer. As described above, the epitaxial layer can be doped to a concentration of about 1 E14 atoms/cm³ to about 1E17 atoms/cm³, while the semiconductor layer 20 can be doped to a concentration of about 1 E19 atoms/cm³ to about 5E20 atoms/cm³. Thus the epitaxial layer 32 has a higher resistance than the semiconductor layer 20. Because the lower extension 18 of the gate shield 16 extends through the epitaxial layer 32, the resistance of the epitaxial layer is not a factor in the current measurement of the first current sensor 21. Similarly, the top electrode 36 of the second current sensor 35 extends through the epitaxial layer 32 and into a trench in the semiconductor substrate 20, and the resistance of the epitaxial layer is not a factor in the current measurement of the current sensor.

As also discussed above, the transistor gate shield 16 is not a necessary element of the invention. If the gate shield is absent, the top electrode 22 can extend through the various layers, including the epitaxial layer 32, and into the trench within the semiconductor substrate 20, similar to the top electrode 36 of the second sensor 35.

In this embodiment, top electrode 22 is formed to contact the gate shield metal 16. Thus the conductor 22 and gate shield metal 16 can together function as the top electrode for the high side current sensor 21. Thus, electrode portions 22, 16, and 38 can be used to measure the substrate resistance 34. As discussed above, in this embodiment the phase node of the PowerDie 10 is the source of the high side transistor and the drain of the low side transistor, which are electrically shorted together. Other implementations are also contemplated.

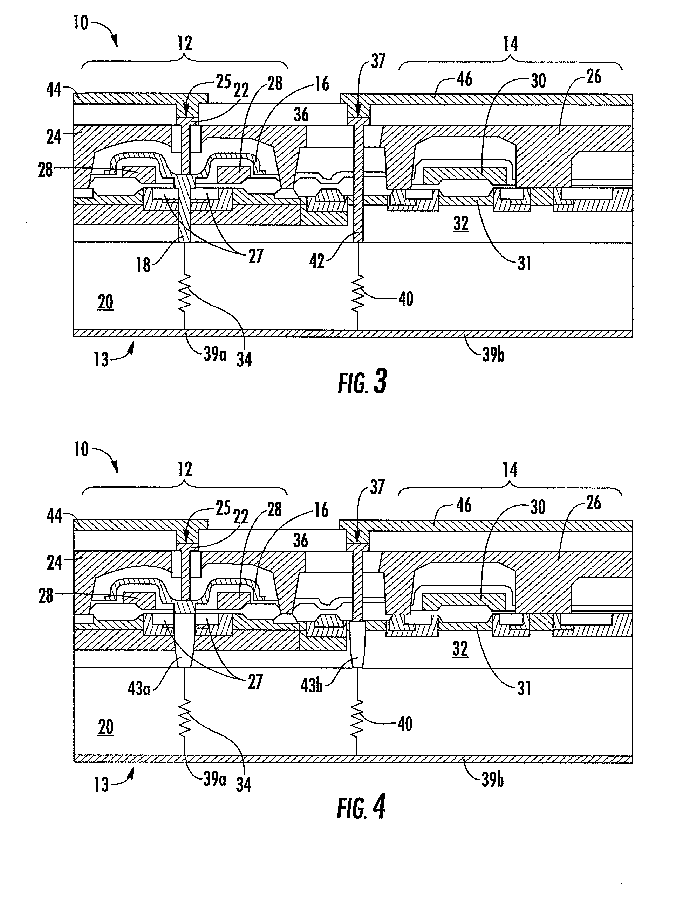

In an embodiment to form the electrodes, trenches can be etched into a depth within the semiconductor substrate 20 as depicted in FIG. 1, for example. In another embodiment, which can be similar to that depicted in FIG. 3, the epitaxial layer 32 is etched to a depth sufficient to just expose a junction (i.e. the interface) between the semiconductor substrate 20 and the epitaxial layer 32. That is, the trenches are sufficiently deep to just expose a first surface (a front surface) of the semiconductor substrate 20, while the bottom electrode 38 is formed on a second surface (a back surface) of the semiconductor substrate 20 which is opposite the first surface. The trenches can be filled with a conductor which will form electrode portions 18 and 42 which electrically and physically contact the semiconductor substrate 20. Forming the electrodes to just contact the semiconductor substrate 20 as depicted in FIG. 3 will provide a full thickness of the semiconductor substrate 20 for measurement. Conductors can include one or more silicide layers of metals such as titanium, cobalt, platinum, nickel, etc. which electrically contact the silicon along with a barrier layer (TiN, TiW, TiWN, TaN, Co, Ni) and a low resistance high-temperature conductive layer (W, WSix, etc.). Doped polysilicon may also be used, as well as a highly doped diffusion region (sometimes referred to as "sinker diffusions").

Measuring resistance using a full semiconductor substrate thickness will increase accuracy of the resulting measurement. A trench depth can be from 0 µm to about 5 µm into the semiconductor substrate. A deeper target depth into the semiconductor substrate 20 will reduce the likelihood of an under etch, but may decrease measurement accuracy.

The substrate trenches into which conductor 18, 42 are formed can be anisotropically etched to provide more vertically oriented sidewalls, with a slope which can be adjusted to ensure appropriate trench fill. An isotropic etch component can be added to the etch, for example to provide trench corner rounding to result in a "U" shaped trench, or to provide a "V" shaped trench. The bottom of the conductors 18, 42 should electrically form an ohmic contact to the semiconductor substrate 20.

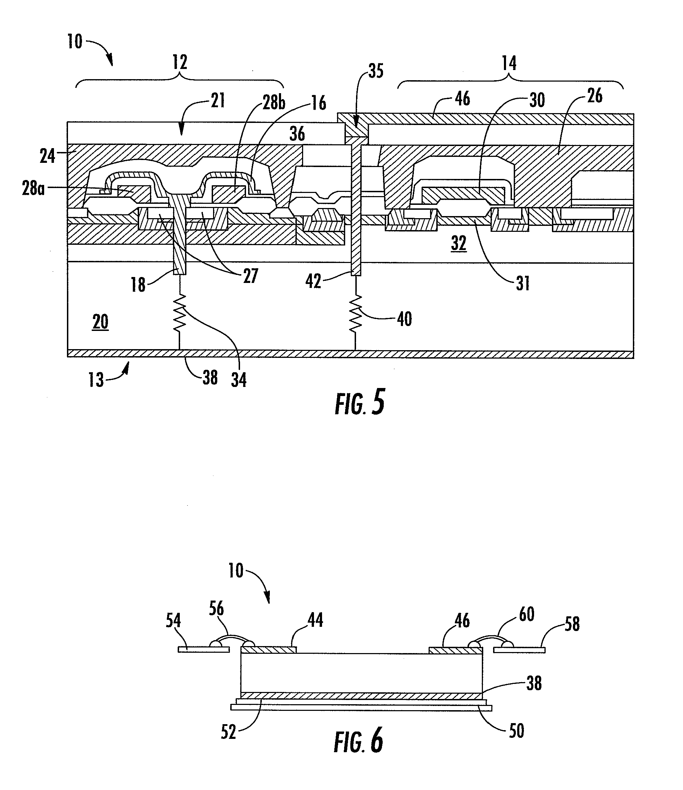

In another embodiment, depicted in FIG. 4, the lower extension 18 of the gate shield 16 and the lower extension 42 of the second current sensor top electrode 38 can be heavily implanted regions which extend through the epitaxial layer 32 to the semiconductor substrate 20 rather than the metal depicted in FIG. 1 FIG. 6 depicts a first implanted region 43A within the epitaxial layer 32 for the first current sensor 21, and a second implanted region 43B within the epitaxial layer 32 for the second current sensor 35. Region 43A can be implanted subsequent to forming an opening into which gate shield 16 will be formed, and prior to forming the gate shield conductor. Region 43B can be implanted subsequent to forming an opening into which top electrode 36 will be formed, and prior to forming the conductor within the opening.

The top electrode 22 of the first current sensor 21 which contacts gate shield 16 can be provided on the top surface of the device 10. Top electrode 22 can be located opposite bottom electrode 38, which electrically contacts the phase node (i.e. the bottom of the semiconductor substrate 20). A differential voltage signal between top electrode 22 and bottom electrode 38 is proportional to the current flow through semiconductor substrate 20, as is the differential voltage between top electrode 36 and bottom electrode 38. The differential voltage signal will also be proportional to the area of the FET within which each sensor is placed, as well as the location of the top and bottom electrodes relative to the current flow through the semiconductor substrate.

In another embodiment depicted in FIG. 5, a single top electrode (sense pad) can be placed on the circuit side of the device (i.e. a side of the device having circuitry such as a transistor gate and/or conductive interconnect lines formed thereon) at a location interposed between the gate of the low side FET and the gate of the high side FET. The current sensor can be at a location between the gate of the high side transistor and the gate of the low side transistor which is adapted to provide a signal that is proportional to the current flowing through either the high side transistor or the low side transistor during device operation. This single sensor can also use the bottom electrode 38 on the back of the semiconductor substrate 20. Such a device with a single, sensor placed at a favorable location on the semiconductor device may be similar to device 10 of FIG. 1, except that the first sensor 21 would not be formed; the current sensor 35 depicted as such in FIG. 5, would function as the single sensor.

FIG. 6 depicts a semiconductor die such as die 10 of FIG. 1 which includes a current sensor as described above in which the bottom electrode 38 is electrically coupled to a lead frame die pad 50 through a conductive die attach material 52. FIG. 6 further depicts a lead frame first lead 54 which is electrically coupled with the top electrode 22 of the first sensor 21 through conductive layer 44 and an electrical conductor 56 which electrically couples the conductive layer 44 to the lead frame first lead 54. A lead frame second lead 58 is electrically coupled with the top electrode 36 of the second sensor 35 through conductive layer 46, and another electrical conductor 60. As depicted, electrical conductors 56, 60 are bond wires, but other electrical conductors such as copper clips may be used, or the lead frame may be placed over the conductive layers 44, 46 and connected to them using an electrical conductor such as solder, conductive die attach material, etc.

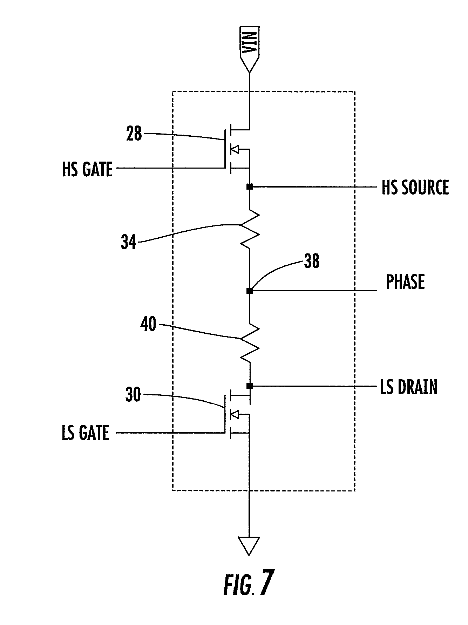

FIG. 7 is a schematic depiction of the FIG. 1 device.

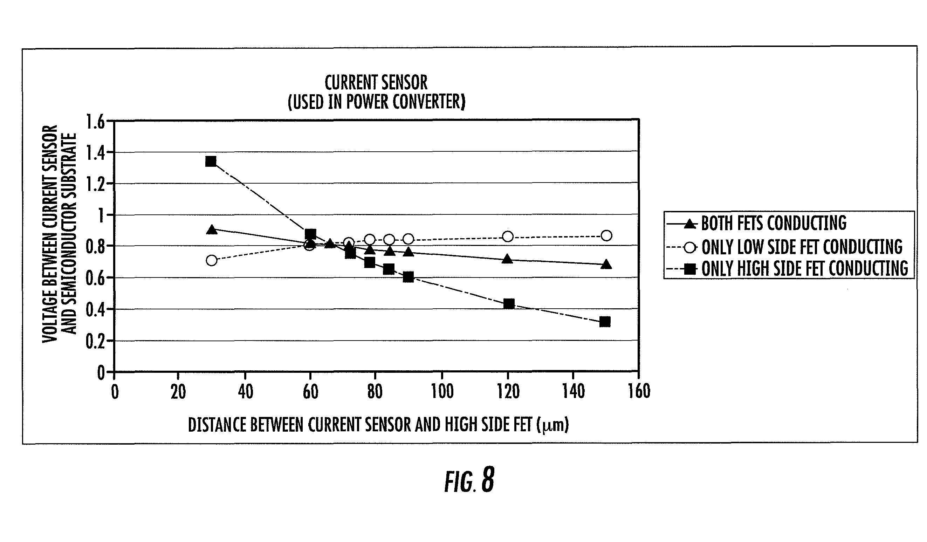

FIG. 8 is a graph depicting results of a simulation for a DC to DC converter including a low side FET, a high side FET, and a single current sensor, such as the device depicted in FIG. 5. For the simulated FIG. 5 device, a distance from the left edge 33 of the low side FET 14 to the right edge 37 of the top electrode 36 of the current sensor 35 remains at 30 µm. A distance between the right edge 41 of the high side FET 12 to the left edge 45 of the top electrode 36 of the current sensor 35 is varied. The simulated device includes a current sensor bottom electrode provided by bottom electrode 38 of the current sensor 34 as depicted. The bottom electrode 38 can cover the bottom side of the single semiconductor substrate 20, and provides an output node (i.e. phase node, switched node) for the DC to DC converter as described above. At each distance between the high side FET 12 and current sensor 35, the voltage between the lower extension 42 of the top electrode 36 and the and the bottom electrode 38 is extracted during three different simulation conditions: 1) when both the high side FET 12 and the low side FET 14 are conducting to the bottom electrode 38, 2) when only the low side FET 14 is conducting and the high side FET 12 is not conducting to the bottom electrode 38, and 3) when only the high side FET 12 is conducting and the low side FET 14 is not conducting to the bottom electrode 38.

The three different curves of FIG. 8 correspond to the three different conditions discussed in the previous paragraph. Each data point along a curve indicates the simulated distance between the high side FET 12 (referring to FIG. 5) and the left edge 45 of the top electrode 36 of the current sensor 35. The distance between the low side FET 14 and the right edge 37 of the top electrode 36 remains at 30 µm.

The crossover point of the three curves indicates that a current sensor location exists where the measured voltage drop from the current sensor top electrode 36 to the current sensor bottom electrode 38 remains constant regardless of whether the current is flowing through the high side FET only 14, the low side FET only 12, or both the high side FET 14 and the low side FET 12. That is, the die location (i.e. position) of the current sensor is chosen such that a measured voltage difference between the top electrode 36 and the bottom electrode 38 of the current sensor 35 (i.e. the measured sensor to substrate voltage) is the same for a given current regardless of which FET is conducting to the bottom electrode, or whether both FETs are conducting.

In this embodiment, the crossover point occurs when the distance between the high side FET 14 and the top electrode 36 of the current sensor 35 is 66 µm, or about 66 µm. As stated above, the distance between the low side FET 14 in this simulation remains at 30 µm. The location of the current sensor which produces the crossover point is a desired location, because a current sensor at this location produces an accurate substrate current measurement which is minimally affected by the operation status of the FETs on the die. The desired location can be determined using a device simulation or can be calculated using a simplified version of a device simulation as a calculator for various design elements of the semiconductor device, for example the operational current values of the FETs, the surface area covered by the high side FET 12 and the low side FET 14, and the spacing between the two FETs.

Thus the present teachings provide a method and structure to measure a voltage drop across a semiconductor substrate. The measured voltage drop can be used to determine the current flow through a power supply, through semiconductor device module, and/or through a "PowerDie."

For purposes of this application, a "PowerDie" includes a DC to DC converter having a high side FET and a low side FET on a die which includes a single semiconductor substrate. The semiconductor substrate can be a semiconductor wafer, a semiconductor wafer section, an epitaxial layer, or a semiconductor wafer or wafer section having an epitaxial layer formed thereupon. A resistance of the semiconductor substrate is not as variable as the entire FET resistance, thus there may be a smaller measurement error. The current can be sensed whether a given FET is on or off. A separate measurement FET is not necessary, thus processing is simplified and die area is freed up for other uses. In an embodiment which uses a single top electrode in combination with the bottom electrode, a well-placed pad can measure the current flowing through any portion of the high side FET or low side FET.

A current sensor (sense resistor) according to an embodiment of the present teachings can provide continuous measurement of the current flowing through the semiconductor substrate. Continuous measurement can occur whether one or more FETs (for example, one or more of the high side FETs 12 at the first location and the low side FET 14 at the second location) is on, off, or switching. Sense elements which measure current are beneficial for voltage regulators such as DC to DC converters, for example switching synchronous buck regulators.

In device simulations, the desired location of the sense electrode is independent of current, temperature, and substrate resistance. That is, the desired location measured by the distance of the sense electrode from the low side FET and from the high side FET does not change with changing current, temperature, and/or substrate resistance. In the embodiment depicted, simulation suggests that a desired location for a single sensor occurs when the top sense electrode is 66 µm from the high side FET when the distance from the top sense electrode to the low side FET is 30 µm. The actual desired layout will vary with device sizing, layout, and/or materials; however, a desired electrode location can be measured during device design and targeted for production devices.

In an embodiment, the sensor can be implemented with a PowerDie structure (i.e. a DC to DC converter having a high side FET and a low side FET provided on the same piece of semiconductor substrate).

The approach described above can be generalized to other devices with a vertical current flow by one of ordinary skill in the art from the information herein. In an embodiment, a highly doped substrate is connected to a current sensor top electrode on the top surface of the substrate and to a current sensor bottom electrode on the bottom surface of the substrate. The bottom electrode can provide the die attach area of the die. In this case, the bottom of the die can function as both the bottom electrode and the switched node (i.e. the phase node) of the PowerDie device.

High side and low side transistor structures for the DC to DC converter can be provided by trench gate DMOS devices, vertical planar gate DMOS devices, N-channel FETs, P-channel FETs, insulated gate bipolar transistors (IGBTs), bipolar transistors, LDMOS with bottom drain connections, LDMOS with bottom source connections, high electron mobility transistors with bottom source or drain connections, a combination of two or more of these or other devices, etc.

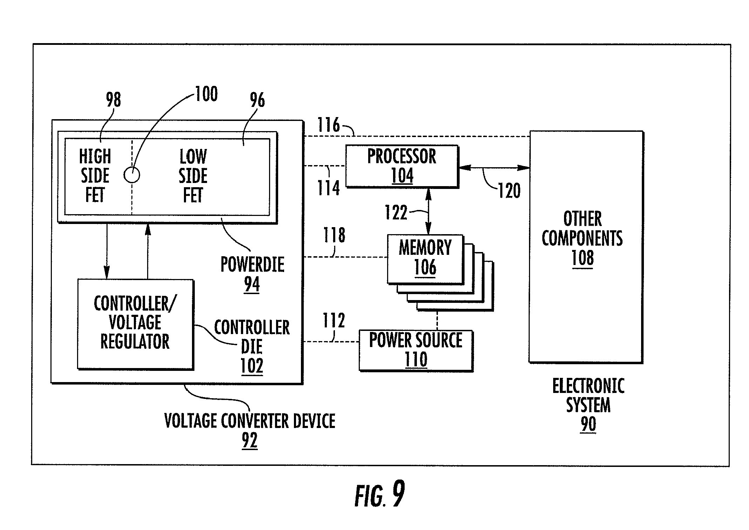

A semiconductor device including a current sensor as described above may be attached along with other semiconductor devices such as one or more microprocessors to a printed circuit board, for example to a computer motherboard, for use as part of an electronic system such as a personal computer, a minicomputer, a mainframe, or another electronic system. A particular embodiment of an electronic system 90 according to the present teachings is depicted in the block diagram of FIG. 9. The electronic system 90 can include a semiconductor device such as a voltage converter device 92, for example a DC to DC power converter. The voltage converter device 92 can include a first die (e.g. a PowerDie) 94 having a low side LDMOS FET 96, a high side LDMOS FET 98, and a current sensor 100 on the same semiconductor substrate (i.e. the same piece of semiconductor material, such as a single silicon die, gallium die, etc.). The current sensor 100 can be provided between the high side FET 98 and the low side FET 96 as depicted, and used to measure load current of the PowerDie. The voltage converter device 92 can further include and a second die (e.g. a controller die) 102 which can include a controller/voltage regulator adapted to control the voltage converter device 92. The electronic system 90 can further include a processor 104 which may be one or more of a microprocessor, microcontroller, embedded processor, digital signal processor, or a combination of two or more of the foregoing. Electronic system 90 can further include one or more memory devices 106 such as static random access memory, dynamic random access memory, read only memory, flash memory, or a combination of two or more of the foregoing. Other components 108 such as video cards, digital video disks, optical drives, universal serial bus (USB) hardware, etc. can also be included, which will vary with the type of electronic system 90. The voltage converter device 92 can be powered by a power source (power supply) 110 through a first power bus 112. The power source 110 may be a converted AC power source or a DC power source such as a DC power supply or battery. The processor 104 can be powered through a second power bus 114 using electricity converted by the voltage converter device 92. The other components 108 can be powered through a third power bus 116 using electricity converted by the voltage converter device 92. The memory 106 can be powered through a fourth power bus 118 using electricity converted by the converter device 92 or, in a alternate embodiment, through a different power management IC set. Data can be passed between the processor 104 and the other components 108 along a first data bus 120. Data can be passed between the processor 104 and the memory 106 along a second data bus 122. Thus electronic system 90 may be a device related to telecommunications, the automobile industry, semiconductor test and manufacturing equipment, consumer electronics, or virtually any piece of consumer or industrial electronic equipment.

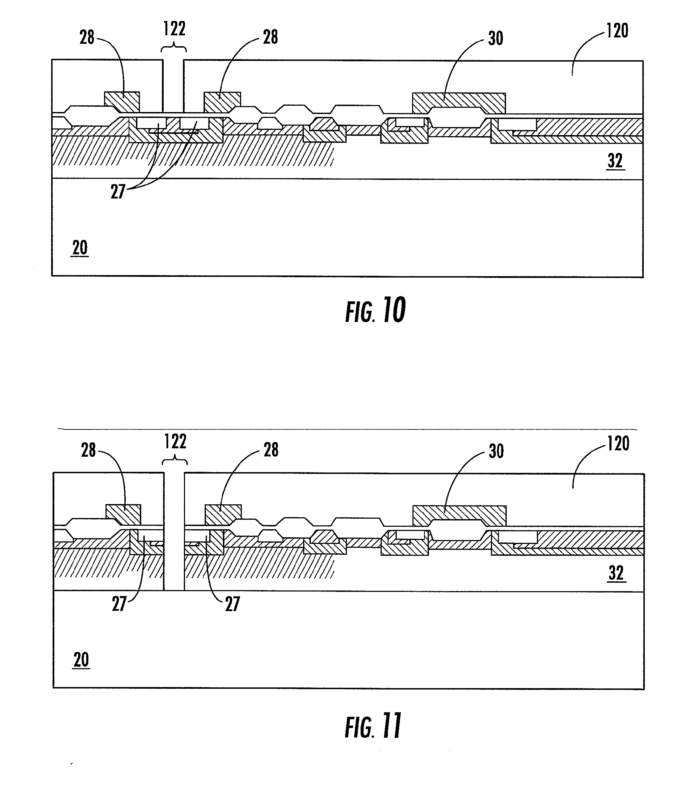

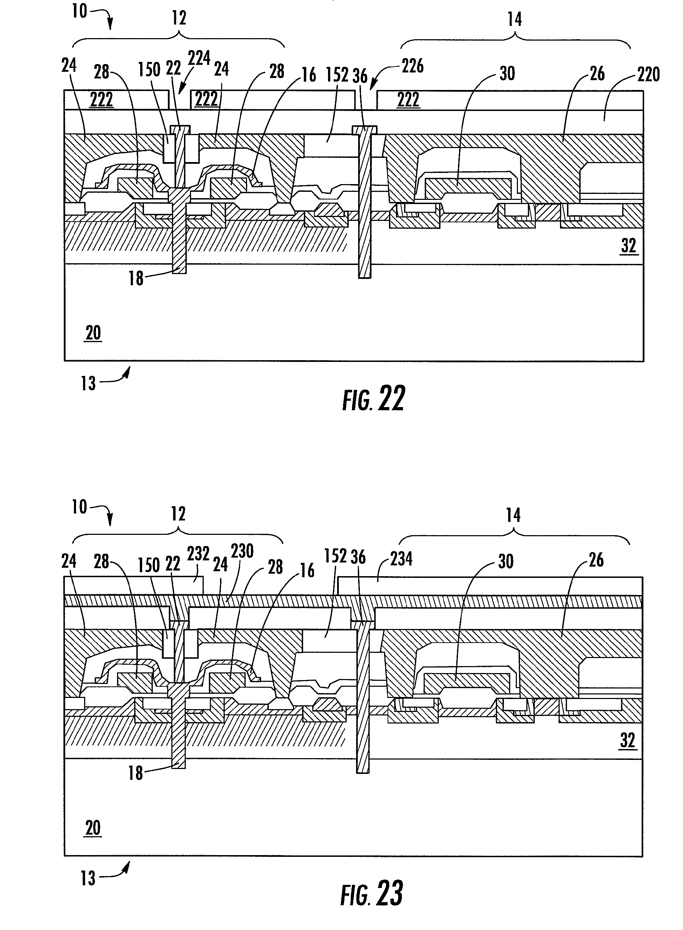

FIGS. 10-22 depict a method which can be used to form one or more current sensors in accordance with the previous embodiments. In FIG. 10, a doped epitaxial layer 32 is formed over a semiconductor substrate 20 such as a silicon wafer. Various other structures can be formed on and within the epitaxial layer 32 and the semiconductor substrate 20, depending on the semiconductor device being formed. For purposes of illustration, the structures can include those as described and formed with reference to FIG. 22 of U.S. application 12/470,229, incorporated above.

Fig. 10 further depicts a patterned mask 120 such as a photoresist (resist) layer having at least one opening therein 122.

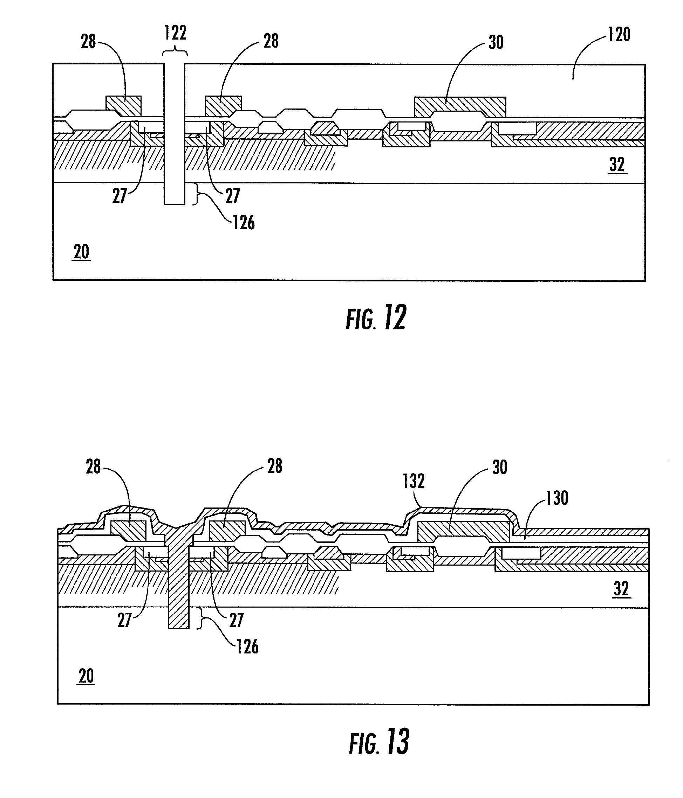

The process can continue with an implant of dopants through opening 122 to form heavily doped region 43A of FIG. 4. In an alternate embodiment, a vertical etch can be performed to etch an opening or trench in the epitaxial layer 32 as depicted in FIG. 11. The opening is formed deep enough to at least expose the semiconductor substrate 20 as depicted in FIG. 11. If the process is continued without etching the semiconductor substrate 20, a current sensor such as current sensor 25 in FIG. 3 can be formed. However, if the etch is continued to etch the semiconductor substrate 20 to form a trench 126 therein, a structure such as current sensor 21 in FIG. 2 can be formed. Etching the semiconductor substrate 20 to form a trench 126 will guard against an under etch and ensure that semiconductor substrate 20 is exposed. However, omitting the trench in the semiconductor substrate 20 and terminating the etch just as the semiconductor substrate 20 is exposed will ensure that a full thickness of the semiconductor substrate 20 is measured by the current sensor, and will result in a more accurate measurement. The process described below will include formation of the trench 126 in the semiconductor substrate 20 as depicted in FIG. 12, but it will be understood that the process can continue without forming the trench using the structure of FIG. 3.

After forming the FIG. 12 structure, the resist 120 is removed. A patterned dielectric 130 such as oxide and a conductive blanket gate shield layer 132 is formed as depicted in FIG. 13. This results in the formation of the conductive blanket gate shield layer 132 within the trench 126, which is electrically coupled to the semiconductor substrate 20 through contact therewith. The process can continue as described and formed with reference to FIG. 25 of U.S. application 12/470,229.

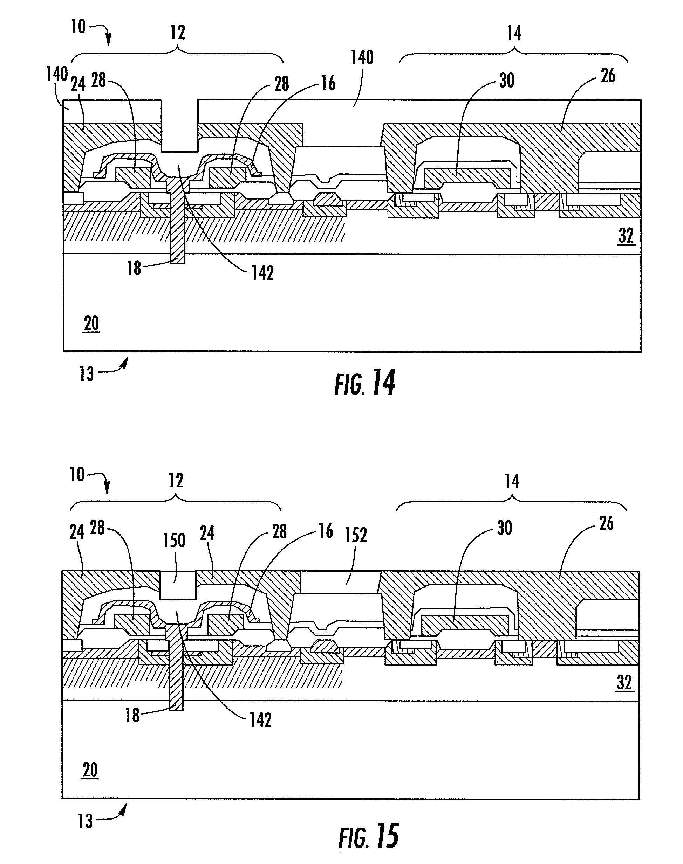

Subsequently, conductive layer 24, 26 can be planarized, and a patterned resist layer 140 is formed to expose the high side drain region 24. The high side drain region 24 is etched to expose oxide 142 to result in the FIG. 14 structure. The resist layer 140 is removed, then a blanket dielectric layer is formed and planarized to result in dielectric portions 150, 152 as depicted in FIG. 15.

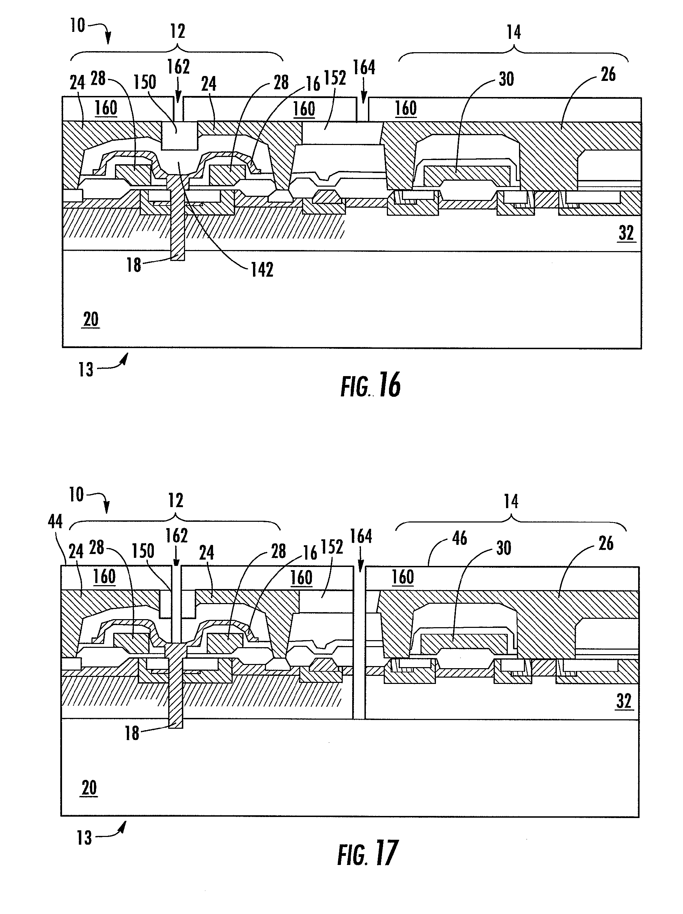

Next, a patterned resist layer 160 is formed to include a first opening 162 and a second opening 164. The first opening 162 is formed to expose the gate shield 16, and the second opening 164 is formed to expose the semiconductor substrate 20 at a location where a second current sensor will be formed. Next, dielectric 150 and 142 are etched to expose the gate shield 16, with the etch stopping on the gate shield 16. Additionally, dielectric layer 152, epitaxial layer 32, and other layers overlying the semiconductor substrate 20 are etched to at least expose the semiconductor substrate 20 as depicted in FIG. 17, then the patterned resist layer 160 is removed.

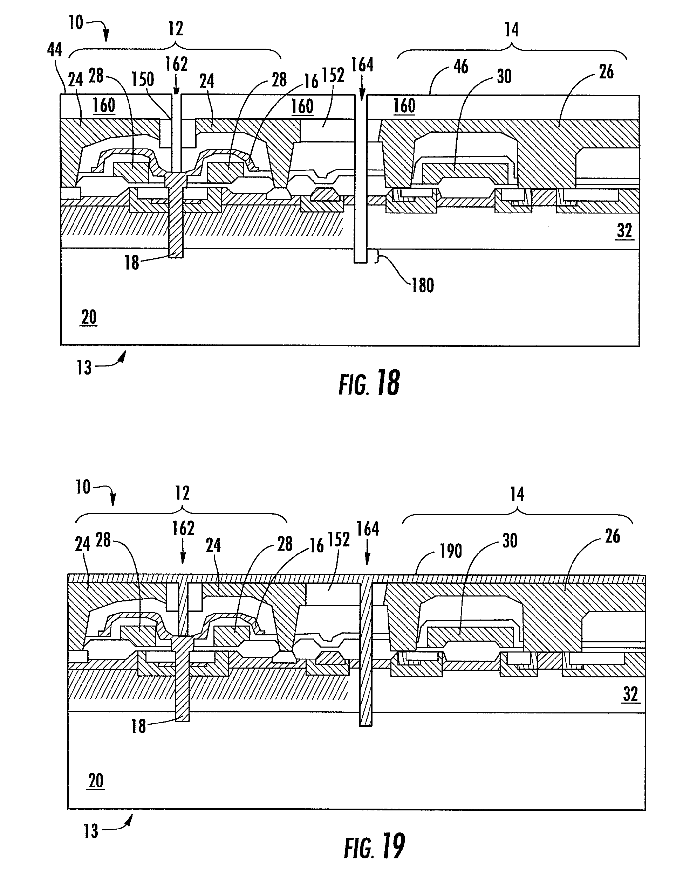

At this point, a dopant implant through opening 164 can be performed to result in a conductive heavily implanted region 43B as depicted in FIG. 4. In an alternate process, a conductor can be formed within openings 162, 164 at this point to eventually form the structure of FIG. 3. However, the etch can continue into the semiconductor substrate 20 as depicted in FIG. 18 to form a trench 180. Forming a trench 180 within semiconductor substrate 20 will guard against an under etch of epitaxial layer 32. However, stopping the etch on the semiconductor substrate 20 as depicted in FIG. 17 will result in a full thickness of semiconductor substrate 20, which can result in greater accuracy of the measurement by a subsequently formed second current sensor.

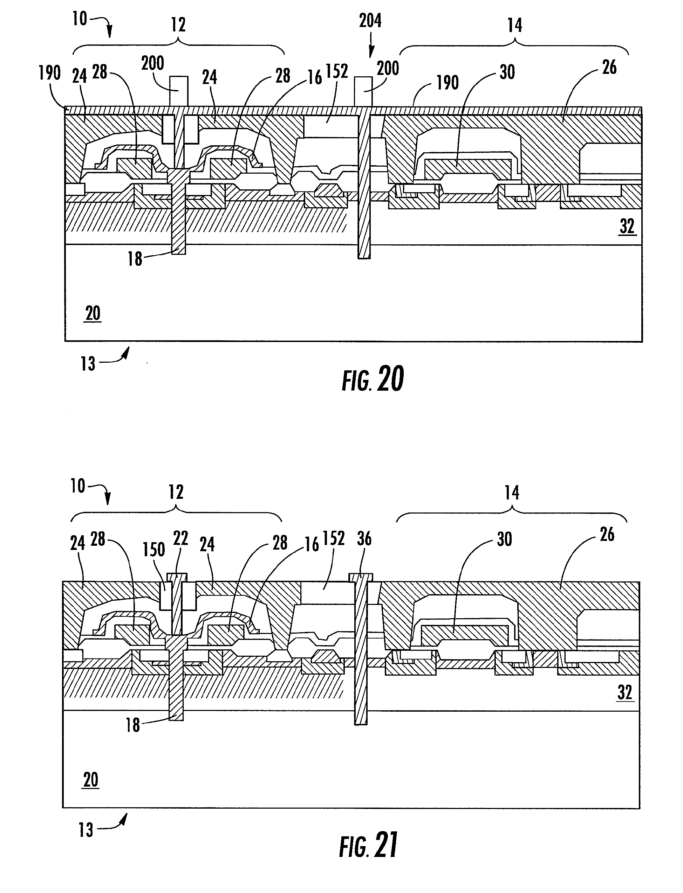

After forming the FIG. 18 structure, the resist layer 160 is removed and a blanket conductive layer 190 is formed as depicted in FIG. 19 to fill the openings which to expose the gate shield 16 and the semiconductor substrate 20. Layer 190 makes electrical contact to gate shield 16 and the semiconductor substrate 20, for example through direct physical contact and/or though contact with another conductive structure such as gate shield 16. A patterned resist layer 200 is formed over the conductive layer 190 as depicted in FIG. 20, then an etch is performed to define first current sensor top electrode 22 and second current sensor top electrode 36 as depicted in FIG. 21. Dielectric layer 150 electrically isolates first current sensor top electrode 22 from high side drain 24.

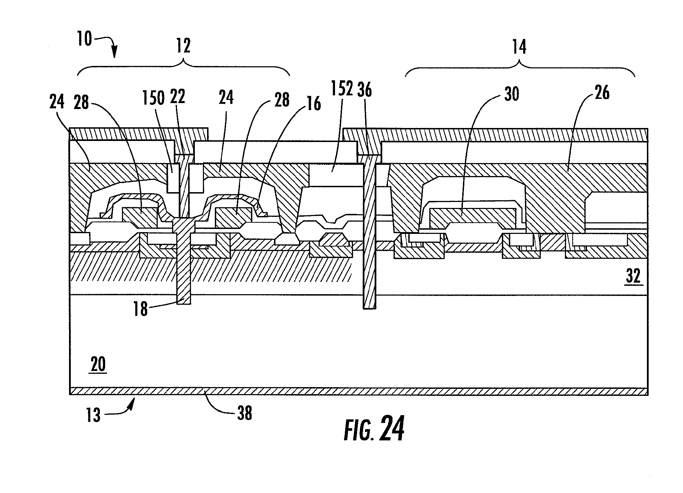

Next, contacts to the first current sensor top electrode 22 and the second current sensor top electrode 36 can be formed. In an exemplary process, a blanket dielectric layer 220 is formed, and a patterned resist layer 222 is formed with openings 224, 226 which expose the first current sensor top electrode 22 and the second current sensor top electrode 36 respectively. The dielectric layer 220 is etched to expose top electrodes 22, 36, the resist 222 is removed, then a blanket conductive layer 230 is formed as depicted in FIG. 23. A patterned resist layer 232 is formed to define individual contacts to each of the top electrodes 22, 36, then the blanket conductive layer 230 is etched to form a first contact 240 to the first current sensor top electrode 22 and a second contact 242 to the second current sensor top electrode 36 as depicted in FIG. 24. Next a bottom electrode 38 can be formed over the back of the semiconductor substrate 20 to result in the FIG. 24 structure. This completed structure can be similar to the structure of FIG. 1.

Notwithstanding that the numerical ranges and parameters setting forth the broad scope of the present teachings are approximations, the numerical values set forth in the specific examples are reported as precisely as possible. Any numerical value, however, inherently contains certain errors necessarily resulting from the standard deviation found in their respective testing measurements. Moreover, all ranges disclosed herein are to be understood to encompass any and all sub-ranges subsumed therein. For example, a range of "less than 10" can include any and all sub-ranges between (and including) the minimum value of zero and the maximum value of 10, that is, any and all sub-ranges having a minimum value of equal to or greater than zero and a maximum value of equal to or less than 10, e.g., 1 to 5. In certain cases, the numerical values as stated for the parameter can take on negative values. In this case, the example value of range stated as "less than 10" can assume negative values, e.g. ― 1, -2, -3, -10, -20, -30, etc.

While the present teachings have been illustrated with respect to one or more implementations, alterations and/or modifications can be made to the illustrated examples without departing from the spirit and scope of the appended claims. In addition, while a particular feature of the present teachings may have been disclosed with respect to only one of several implementations, such feature may be combined with one or more other features of the other implementations as may be desired and advantageous for any given or particular function. Furthermore, to the extent that the terms "including," "includes," "having," "has," "with," or variants thereof are used in either the detailed description and the claims, such terms are intended to be inclusive in a manner similar to the term "comprising." The term "at least one of" is used to mean one or more of the listed items can be selected. Further, in the discussion and claims herein, the term "on" used with respect to two materials, one "on" the other, means at least some contact between the materials, while "over" means the materials are in proximity, but possibly with one or more additional intervening materials such that contact is possible but not required. Neither "on" nor "over" implies any directionality as used herein. The term "conformal" describes a coating material in which angles of the underlying material are preserved by the conformal material. The term "about" indicates that the value listed may be somewhat altered, as long as the alteration does not result in nonconformance of the process or structure to the illustrated embodiment. Finally, "exemplary" indicates the description is used as an example, rather than implying that it is an ideal. Other embodiments of the present teachings will be apparent to those skilled in the art from consideration of the specification and practice of the present teachings disclosed herein. It is intended that the specification and examples be considered as exemplary only, with a true scope and spirit of the present teachings being indicated by the following claims.

Terms of relative position as used in this application are defined based on a plane parallel to the conventional plane or working surface of a wafer or semiconductor substrate, regardless of the orientation of the wafer or substrate. The term "horizontal" or "lateral" as used in this application is defined as a plane parallel to the conventional plane or working surface of a wafer or substrate, regardless of the orientation of the wafer or substrate. The term "vertical" refers to a direction perpendicular to the horizontal. Terms such as "on," "side" (as in "sidewall"), "higher," "lower," "over," "top," and "under" are defined with respect to the conventional plane or working surface being on the top surface of the wafer or substrate, regardless of the orientation of the wafer or substrate.

A semiconductor device of the invention, comprises: a semiconductor substrate; a current sensor, comprising: a top electrode electrically coupled to a first surface of the semiconductor substrate; and a bottom electrode electrically coupled to a second surface of the semiconductor substrate which is opposite the first surface of the semiconductor substrate, wherein the current sensor is adapted to provide a measurement of a current flowing through the semiconductor substrate. Preferably, the semiconductor device further comprises: a trench within the semiconductor substrate; and a conductor within the trench which is electrically coupled with the semiconductor substrate, wherein the current sensor further comprises the conductor within the trench.
Preferably, the semiconductor device of the invention further comprises: an electrical conductor which electrically couples the top electrode to a lead frame.
Preferably, in the semiconductor device of the invention the current sensor is a first current sensor and the semiconductor device further comprises: a second current sensor comprising: a top electrode electrically coupled to the first surface of the semiconductor substrate; and a bottom electrode electrically coupled to the second surface of the semiconductor substrate which is opposite the first surface of the semiconductor substrate; the first current sensor is adapted to provide a first current measurement of a first current flowing through the semiconductor substrate; and the second current sensor is adapted to provide a second current measurement of a second current flowing through the semiconductor substrate.
Preferably, the semiconductor device further comprises: a first electrical conductor which electrically couples the top electrode of the first current sensor to a lead frame first lead; a second electrical conductor which electrically couples the top electrode of the second current sensor to a lead frame second lead; and a conductive die attach material which electrically couples the bottom electrode of the first current sensor and the bottom electrode of the second current sensor to a lead frame die pad.
Preferably, in the semiconductor device of the invention the current sensor is adapted to provide a continuous measurement of current flowing through the semiconductor substrate whether a field effect transistor formed over and within the semiconductor substrate is on, off, or switching.

A further semiconductor device of the invention, comprises: a semiconductor die comprising: a single semiconductor substrate; a high side transistor over the single semiconductor substrate, wherein the high side transistor comprises a drain electrically coupled to a device voltage in (VIN) pinout and a source; a low side transistor over the single semiconductor substrate, wherein the low side transistor comprises a source electrically coupled to a device ground (PGND) pinout and a drain; and a current sensor comprising: a top electrode electrically coupled to a first surface of the single semiconductor substrate; anda bottom electrode electrically coupled to a second surface of the single semiconductor substrate which is opposite the first surface of the single semiconductor substrate, wherein: the source of the high side transistor and the drain of the low side transistor are electrically coupled to the bottom electrode of the current sensor; and the current sensor is adapted to provide a measurement of a current flowing through the single semiconductor substrate.
Preferably, the semiconductor device further comprises: a portion of the high side transistor directly interposed between the top electrode and the single semiconductor substrate.
Preferably, the semiconductor device further comprises: a gate shield which overlies a transistor gate of the high side transistor and is electrically coupled to the semiconductor substrate; the top electrode electrically contacts the gate shield and is electrically coupled to the single semiconductor substrate through the gate shield; and a thickness of the single semiconductor substrate is interposed between the top electrode and the bottom electrode.
Preferably, in the semiconductor device a lower extension of the gate shield extends through an epitaxial layer which overlies the single semiconductor substrate and into a trench within the single semiconductor substrate, and is electrically coupled to the single semiconductor substrate.
Preferably, in the semiconductor device the gate shield is directly interposed between the top electrode and the single semiconductor substrate.
Preferably, the semiconductor device further comprises: the single semiconductor substrate comprises a trench therein; the top electrode comprises a portion which extends into the trench within the single semiconductor substrate.
Preferably, the semiconductor device further comprises: an epitaxial layer overlying the single semiconductor substrate, wherein the top electrode extends through the epitaxial layer and into the trench within the single semiconductor substrate. Preferably, in the semiconductor device the bottom electrode is electrically coupled to a source of the high side transistor and to a drain of the low side transistor. Preferably, in the semiconductor device the bottom electrode provides a contact to a switched node of the semiconductor device.
Preferably, in the semiconductor device the current sensor is a first current sensor and the semiconductor device further comprises: a second current sensor comprising: a top electrode electrically coupled to the first surface of the single semiconductor substrate; and a bottom electrode electrically coupled to the second surface of the single semiconductor substrate which is opposite the first surface of the single semiconductor substrate; the first current sensor is adapted to provide a first current measurement of a first current flowing through the high side transistor; and the second current sensor is adapted to provide a second current measurement of a second current flowing through the low side transistor.
Preferably, in the semiconductor device the current sensor is adapted to provide a continuous measurement of current flowing through the single semiconductor substrate whether one or more of the high side transistor and the low side transistor is on, off, or switching.
Preferably, the semiconductor device further comprises: a transistor gate of the high side transistor; a transistor gate of the low side transistor; the current sensor is interposed between the gate of the high side transistor and the gate of the low side transistor; and the current sensor is at a location between the gate of the high side transistor and the gate of the low side transistor which is adapted to provide a signal that is proportional to a current flowing through either the high side transistor or the low side transistor during device operation.
Preferably, the semiconductor device further comprises: the current sensor is at a location where a measured voltage drop from the current sensor top electrode to the current sensor bottom electrode remains constant while current is flowing through the high side transistor and not through the low side transistor, while current is flowing through the low side transistor and not the high side transistor, and while current is flowing through both the high side transistor and the low side transistor. Preferably, the semiconductor device further comprises: the current sensor is at a location where a measured voltage difference between the top electrode and the bottom electrode of the current sensor is the same for a given current while current is flowing through the high side transistor and not through the low side transistor, while current is flowing through the low side transistor and not the high side transistor, and while current is flowing through both the high side transistor and the low side transistor.

An electronic system of the invention, comprises: a direct current (DC) to DC converter, comprising: a first semiconductor substrate; a high side transistor over the first semiconductor substrate, wherein the high side transistor comprises a drain electrically coupled to a device voltage in (VIN) pinout and a source; a low side transistor over the first semiconductor substrate, wherein the low side transistor comprises a source electrically coupled to a device ground (PGND) pinout and a drain; a second semiconductor substrate different from the first semiconductor substrate; a controller over the second semiconductor substrate and adapted to control the DC to DC converter; and a current sensor comprising: a top electrode electrically coupled to a first surface of the single semiconductor substrate; and a bottom electrode electrically coupled to a second surface of the single semiconductor substrate which is opposite the first surface of the single semiconductor substrate, wherein: the source of the high side transistor and the drain of the low side transistor are electrically coupled to the bottom electrode of the current sensor; and the current sensor is adapted to provide a measurement of a current flowing through the single semiconductor substrate; a power supply electrically coupled to the DC to DC converter through a first power bus and adapted to supply power to the DC to DC converter through the first power bus; a processor electrically coupled to the DC to DC converter through a second power bus, wherein the DC to DC converter is adapted to supply power to the processor through the second power bus; and a data bus adapted to transfer data between at least one memory device and the processor.
Preferably, the electronic system further comprises: a video card electrically coupled to the DC to DC converter through a fourth power bus, wherein the DC to DC converter is adapted to supply power to the video card through the fourth power bus. Preferably, the electronic system further comprises: a digital video disk electrically coupled to the DC to DC converter through a fourth power bus, wherein the DC to DC converter is adapted to supply power to the digital video disk through the fourth power bus.
Preferably, the electronic system further comprises: an optical drive electrically coupled to the DC to DC converter through a fourth power bus, wherein the DC to DC converter is adapted to supply power to the optical drive through the fourth power bus.
Preferably, the electronic system further comprises: a universal serial bus (USB) hardware electrically coupled to the DC to DC converter through a fourth power bus, wherein the DC to DC converter is adapted to supply power to the USB hardware through the fourth power bus.

A method for forming a semiconductor device of the invention, comprises: forming a doped epitaxial layer over a front surface of a semiconductor substrate; etching an opening through the doped epitaxial layer to expose the semiconductor substrate; forming a portion of a top electrode for a current sensor within the opening which electrically contacts the semiconductor substrate; and forming a conductive layer over a back surface of the semiconductor substrate, wherein the back surface is opposite the front surface, and the conductive layer forms a bottom electrode for the current sensor; wherein the current sensor is adapted to provide a measurement of current flowing through the semiconductor substrate.
Preferably, the method of the invention further comprises: forming a first conductor which electrically couples the portion of the current sensor top electrode to a first lead frame lead; forming a second conductor which electrically couples the current sensor bottom electrode to a second lead frame lead; and forming a third conductor which electrically couples the current sensor bottom electrode to a lead frame die pad.
Preferably, in the method of the invention the current sensor is a first current sensor and the opening is a first opening, and the method further comprises: etching a second opening through the doped epitaxial layer to expose the semiconductor substrate; and forming a top portion for a second current sensor within the second opening which electrically contacts the semiconductor substrate; wherein the conductive layer forms a bottom electrode for the second current sensor and the second current sensor is adapted to provide a measurement of current flowing through the semiconductor substrate.
Preferably, the method of the invention further comprises: forming a high side transistor gate over the single semiconductor substrate; implanting a high side transistor source into the doped epitaxial layer; electrically coupling the high side transistor source to the conductive layer; electrically coupling a high side transistor drain to a device voltage in (VIN) pinout; forming a low side transistor gate over the single semiconductor substrate; implanting a low side transistor drain into the doped epitaxial layer; electrically coupling the high side transistor drain to the conductive layer; and electrically coupling a low side transistor source to a device ground (PGND) pinout.
Preferably, in the method of the invention the current sensor is adapted to provide a continuous measurement of current flowing through the semiconductor substrate whether the high side transistor is conducting and the low side transistor is not conducting, the high side transistor is not conducting and the low side transistor is conducting, or both the high side transistor and the low side transistor are conducting.
Preferably, the method of the invention further comprises: during the etching of the opening through the doped epitaxial layer, etching the semiconductor substrate to form a trench therein; and forming the portion of the top electrode within the trench.

## Claims

1. A semiconductor device, comprising:
a semiconductor substrate;
a current sensor, comprising:
a top electrode electrically coupled to a first surface of the semiconductor substrate; and
a bottom electrode electrically coupled to a second surface of the semiconductor substrate which is opposite the first surface of the semiconductor substrate,
wherein the current sensor is adapted to provide a measurement of a current flowing through the semiconductor substrate.

2. The semiconductor device of claim 1, further comprising:
a trench within the semiconductor substrate; and
a conductor within the trench which is electrically coupled with the semiconductor substrate,
wherein the current sensor further comprises the conductor within the trench.

3. The semiconductor device of claim 1, further comprising:
an electrical conductor which electrically couples the top electrode to a lead frame.

4. The semiconductor device of claim 1, wherein the current sensor is a first current sensor and the semiconductor device further comprises:
a second current sensor comprising:
a top electrode electrically coupled to the first surface of the semiconductor substrate; and
a bottom electrode electrically coupled to the second surface of the semiconductor substrate which is opposite the first surface of the semiconductor substrate;
the first current sensor is adapted to provide a first current measurement of a first current flowing through the semiconductor substrate; and
the second current sensor is adapted to provide a second current measurement of a second current flowing through the semiconductor substrate.

5. The semiconductor device of claim 4, further comprising:
a first electrical conductor which electrically couples the top electrode of the first current sensor to a lead frame first lead;
a second electrical conductor which electrically couples the top electrode of the second current sensor to a lead frame second lead; and
a conductive die attach material which electrically couples the bottom electrode of the first current sensor and the bottom electrode of the second current sensor to a lead frame die pad.

6. The semiconductor device of claim 1, wherein the current sensor is adapted to provide a continuous measurement of current flowing through the semiconductor substrate whether a field effect transistor formed over and within the semiconductor substrate is on, off, or switching.

7. A semiconductor device, comprising:
a semiconductor die comprising:
a single semiconductor substrate;
a high side transistor over the single semiconductor substrate, wherein the high side transistor comprises a drain electrically coupled to a device voltage in (V_{IN}) pinout and a source;
a low side transistor over the single semiconductor substrate, wherein the low side transistor comprises a source electrically coupled to a device ground (P_{GND}) pinout and a drain; and
a current sensor comprising:
a top electrode electrically coupled to a first surface of the single semiconductor substrate; and
a bottom electrode electrically coupled to a second surface of the single semiconductor substrate which is opposite the first surface of the single semiconductor substrate, wherein:
the source of the high side transistor and the drain of the low side transistor are electrically coupled to the bottom electrode of the current sensor; and
the current sensor is adapted to provide a measurement of a current flowing through the single semiconductor substrate.

8. The semiconductor device of claim 7, further comprising a portion of the high side transistor directly interposed between the top electrode and the single semiconductor substrate.

9. The semiconductor device of claim 7, further comprising:
a gate shield which overlies a transistor gate of the high side transistor and is electrically coupled to the semiconductor substrate;
the top electrode electrically contacts the gate shield and is electrically coupled to the single semiconductor substrate through the gate shield; and
a thickness of the single semiconductor substrate is interposed between the top electrode and the bottom electrode.

10. The semiconductor device of claim 9, wherein a lower extension of the gate shield extends through an epitaxial layer which overlies the single semiconductor substrate and into a trench within the single semiconductor substrate, and is electrically coupled to the single semiconductor substrate.

11. The semiconductor device of claim 9, wherein the gate shield is directly interposed between the top electrode and the single semiconductor substrate.

12. The semiconductor device of claim 7, further comprising:
the single semiconductor substrate comprises a trench therein;
the top electrode comprises a portion which extends into the trench within the single semiconductor substrate.

13. The semiconductor device of claim 12, further comprising:
an epitaxial layer overlying the single semiconductor substrate, wherein the top electrode extends through the epitaxial layer and into the trench within the single semiconductor substrate.

14. The semiconductor device of claim 7, wherein the bottom electrode is electrically coupled to a source of the high side transistor and to a drain of the low side transistor.

15. The semiconductor device of claim 14, wherein the bottom electrode provides a contact to a switched node of the semiconductor device.

16. The semiconductor device of claim 7, wherein the current sensor is a first current sensor and the semiconductor device further comprises:
a second current sensor comprising:
a top electrode electrically coupled to the first surface of the single semiconductor substrate; and
a bottom electrode electrically coupled to the second surface of the single semiconductor substrate which is opposite the first surface of the single semiconductor substrate;
the first current sensor is adapted to provide a first current measurement of a first current flowing through the high side transistor; and
the second current sensor is adapted to provide a second current measurement of a second current flowing through the low side transistor.

17. The semiconductor device of claim 7, wherein the current sensor is adapted to provide a continuous measurement of current flowing through the single semiconductor substrate whether one or more of the high side transistor and the low side transistor is on, off, or switching.

18. The semiconductor device of claim 7, further comprising:
a transistor gate of the high side transistor;
a transistor gate of the low side transistor;
the current sensor is interposed between the gate of the high side transistor and the gate of the low side transistor; and
the current sensor is at a location between the gate of the high side transistor and the gate of the low side transistor which is adapted to provide a signal that is proportional to a current flowing through either the high side transistor or the low side transistor during device operation.

19. The semiconductor device of claim 7, further comprising:
the current sensor is at a location where a measured voltage drop from the current sensor top electrode to the current sensor bottom electrode remains constant while current is flowing through the high side transistor and not through the low side transistor, while current is flowing through the low side transistor and not the high side transistor, and while current is flowing through both the high side transistor and the low side transistor.

20. The semiconductor device of claim 7, further comprising:
the current sensor is at a location where a measured voltage difference between the top electrode and the bottom electrode of the current sensor is the same for a given current while current is flowing through the high side transistor and not through the low side transistor, while current is flowing through the low side transistor and not the high side transistor, and while current is flowing through both the high side transistor and the low side transistor.

21. An electronic system, comprising:
a direct current (DC) to DC converter, comprising:
a first semiconductor substrate;
a high side transistor over the first semiconductor substrate, wherein the high side transistor comprises a drain electrically coupled to a device voltage in (V_{IN}) pinout and a source;
a low side transistor over the first semiconductor substrate, wherein the low side transistor comprises a source electrically coupled to a device ground (P_{GND}) pinout and a drain;
a second semiconductor substrate different from the first semiconductor substrate;
a controller over the second semiconductor substrate and adapted to control the DC to DC converter; and
a current sensor comprising:
a top electrode electrically coupled to a first surface of the single semiconductor substrate; and
a bottom electrode electrically coupled to a second surface of the single semiconductor substrate which is opposite the first surface of the single semiconductor substrate, wherein:
the source of the high side transistor and the drain of the low side transistor are electrically coupled to the bottom electrode of the current sensor; and
the current sensor is adapted to provide a measurement of a current flowing through the single semiconductor substrate;
a power supply electrically coupled to the DC to DC converter through a first power bus and adapted to supply power to the DC to DC converter through the first power bus;
a processor electrically coupled to the DC to DC converter through a second power bus, wherein the DC to DC converter is adapted to supply power to the processor through the second power bus; and
a data bus adapted to transfer data between at least one memory device and the processor.

22. The electronic system of claim 21, further comprising:
a video card electrically coupled to the DC to DC converter through a fourth power bus, wherein the DC to DC converter is adapted to supply power to the video card through the fourth power bus.

23. The electronic system of claim 22, further comprising:
a digital video disk electrically coupled to the DC to DC converter through a fourth power bus, wherein the DC to DC converter is adapted to supply power to the digital video disk through the fourth power bus.

24. The electronic system of claim 22, further comprising:
an optical drive electrically coupled to the DC to DC converter through a fourth power bus, wherein the DC to DC converter is adapted to supply power to the optical drive through the fourth power bus.

25. The electronic system of claim 22, further comprising:
a universal serial bus (USB) hardware electrically coupled to the DC to DC converter through a fourth power bus, wherein the DC to DC converter is adapted to supply power to the USB hardware through the fourth power bus.

26. A method for forming a semiconductor device, comprising:
forming a doped epitaxial layer over a front surface of a semiconductor substrate;
etching an opening through the doped epitaxial layer to expose the semiconductor substrate;
forming a portion of a top electrode for a current sensor within the opening which electrically contacts the semiconductor substrate; and
forming a conductive layer over a back surface of the semiconductor substrate, wherein the back surface is opposite the front surface, and the conductive layer forms a bottom electrode for the current sensor;
wherein the current sensor is adapted to provide a measurement of current flowing through the semiconductor substrate.

27. The method of claim 26, further comprising:
forming a first conductor which electrically couples the portion of the current sensor top electrode to a first lead frame lead;
forming a second conductor which electrically couples the current sensor bottom electrode to a second lead frame lead; and
forming a third conductor which electrically couples the current sensor bottom electrode to a lead frame die pad.

28. The method of claim 26, wherein the current sensor is a first current sensor and the opening is a first opening, and the method further comprises:
etching a second opening through the doped epitaxial layer to expose the semiconductor substrate; and
forming a top portion for a second current sensor within the second opening which electrically contacts the semiconductor substrate;
wherein the conductive layer forms a bottom electrode for the second current sensor and the second current sensor is adapted to provide a measurement of current flowing through the semiconductor substrate.

29. The method of claim 26, further comprising:
forming a high side transistor gate over the single semiconductor substrate;
implanting a high side transistor source into the doped epitaxial layer;
electrically coupling the high side transistor source to the conductive layer;
electrically coupling a high side transistor drain to a device voltage in (V_{IN}) pinout;
forming a low side transistor gate over the single semiconductor substrate;
implanting a low side transistor drain into the doped epitaxial layer;
electrically coupling the high side transistor drain to the conductive layer; and
electrically coupling a low side transistor source to a device ground (P_{GND}) pinout.

30. The method of claim 29, wherein the current sensor is adapted to provide a continuous measurement of current flowing through the semiconductor substrate whether the high side transistor is conducting and the low side transistor is not conducting, the high side transistor is not conducting and the low side transistor is conducting, or both the high side transistor and the low side transistor are conducting.

31. The method of claim 26, further comprising:
during the etching of the opening through the doped epitaxial layer, etching the semiconductor substrate to form a trench therein; and
forming the portion of the top electrode within the trench.
